# EUROPEAN PATENT APPLICATION

(11) **EP 4 417 732 A1**
(43) Date of publication of application: **21.08.2024**
(21) Application number: 22880594.1
(22) Date of filing: 29.06.2022
(51) Int. Cl.: C23C 16/448, C23C 16/40, H01L 21/365, H01L 21/368

(54) **FILM DEPOSITION DEVICE AND MANUFACTURING METHOD**

(30) Priority: 14.10.2021 JP 2021168663
(71) Applicant: SHIN-ETSU CHEMICAL CO., LTD., Tokyo 1000005 (JP)
(72) Inventor: SAKATSUME Takahiro, Annaka-shi, Gunma 379-0195 (JP)
(74) Representative: Mooser, Sebastian Thomas
(86) International application number: PCT/JP2022/025998
(87) International publication number: WO 2023/062889

(57) **Abstract**

The present invention is a film-forming apparatus including: a mist-generating member to atomize a raw material solution into a mist; a carrier gas-supplying member to supply a carrier gas for carrying the mist generated in the mist-generating member; and a film-forming member to thermally treat the mist carried with the carrier gas to form a film, wherein the film-forming member includes: a film-forming chamber; a substrate-placing member provided inside the film-forming chamber; a nozzle to supply the mist toward the inside of the film-forming chamber; and a gas-discharging member to discharge an exhaust gas from the inside to an outside of the film-forming chamber, and a difference in a height position between an inner face of a ceiling of the film-forming chamber and a substrate-placing face of the substrate-placing member is 0.15 cm or longer and 6.05 cm or shorter. This provides a film-forming apparatus that can form a film with excellent in-plane uniformity of film thickness by mist CVD.

## Description

### TECHNICAL FIELD

The present invention relates to a film-forming apparatus for forming a film on a substrate by using a mist raw material solution, and a film-forming method.

### BACKGROUND ART

Conventionally, there has been development of a high-vacuum film-forming apparatus that can achieve a non-equilibrium state such as pulsed laser deposition (PLD), molecular beam epitaxy (MBE), and sputtering, which have enabled to produce an oxide semiconductor that cannot be produced by a conventional liquid-melting method etc. In addition, there has been development of mist chemical vapor deposition (mist CVD) in which an atomized raw material into a mist is used to grow a crystal on a substrate, which has enabled to produce gallium oxide having a corundum structure (α-Ga₂O₃). The α-Ga₂O₃ is promising as a semiconductor with a large bandgap for application of a next-generation switching device that can achieve high breakdown voltage, low loss, and high heat resistance.

As for the mist CVD, Patent Document 1 describes a tubular-furnace-type mist CVD apparatus. Patent Document 2 describes a fine-channel-type mist CVD apparatus. Patent Document 3 describes a linear-source-type mist CVD apparatus. Patent Document 4 describes a tubular-furnace-type mist CVD apparatus, which differs from the mist CVD apparatus described in Patent Document 1 in terms of introducing a carrier gas into a mist generator. Patent Document 5 describes a mist CVD apparatus in which a substrate is placed above a mist generator, and the substrate is rotated.

### CITATION LIST

### PATENT LITERATURE

Patent Document 1: JP H1-257337 A
Patent Document 2: JP 2005-307238 A
Patent Document 3: JP 2012-46772 A
Patent Document 4: JP 5397794 B
Patent Document 5: WO 2020/261355 A1

### SUMMARY OF INVENTION

### TECHNICAL PROBLEM

The mist CVD, which differs from other CVD, can form a film at relatively low temperature, and can produce a crystal structure with a metastable phase such as the corundum structure of α-Ga₂O₃. However, the present inventors have found a problem that supplying the mist from the above of the substrate disturbs flow of the mist due to thermal convection or mixing of a mist-containing gas and a circumambient gas, which causes difficulty in keeping in-plane uniformity of a thickness of the formed film. A semiconductor film with the low in-plane uniformity causes a problem of decrease in an yield of manufacturing semiconductor devices and a problem of increase in a number of production steps of semiconductor devices such as a polishing step.

Patent Document 5 discloses an example of supplying the mist onto the substrate present above the mist generator while rotating the substrate to form a semiconductor film with good in-plane film-thickness distribution. However, according to Example of Patent Document 5, film formation on a 4-inch (approximately 100 mm in diameter) substrate has a value of minimum film thickness / maximum film thickness = 55.0%, which is not a film with excellent in-plane uniformity of the film thickness. The present inventors have formed a film based on Patent Document 5, and consequently yielded only a film with a thick center and poor in-plane uniformity of the film thickness with the film-forming apparatus described in Patent Document 5. In addition, it has been found that film formation on a 6-inch substrate yields further poorer in-plane uniformity of the film thickness.

The present invention has been made to solve the above problem. An object of the present invention is to provide a film-forming apparatus and film-forming method that can form a film with excellent in-plane uniformity of the film thickness with the mist CVD.

### SOLUTION TO PROBLEM

The present invention has been made to achieve the object. The present invention provides a film-forming apparatus comprising: a mist-generating member to atomize a raw material solution into a mist; a carrier gas-supplying member to supply a carrier gas for carrying the mist generated in the mist-generating member; and a film-forming member to thermally treat the mist carried with the carrier gas to form a film, wherein the film-forming member comprises: a film-forming chamber; a substrate-placing member provided inside the film-forming chamber; a nozzle to supply the mist toward the inside of the film-forming chamber; and a gas-discharging member to discharge an exhaust gas from the inside to an outside of the film-forming chamber, and a difference in a height position between an inner face of a ceiling of the film-forming chamber and a substrate-placing face of the substrate-placing member is 0.15 cm or longer and 6.05 cm or shorter.

According to such a film-forming apparatus, the film with good in-plane uniformity of the film thickness can be formed. A synergistic effect of a rectifying effect by the ceiling of the film-forming chamber and convection generated by supplying the mist through the nozzle and discharging the exhaust gas through the gas-discharging member generates uniform gas flow above the substrate along the substrate (parallel to the substrate surface) to form the uniform film on the substrate.

In this time, in the film-forming apparatus, the inner face of the ceiling of the film-forming chamber and an opening face of the nozzle may be present in an identical plane.

This configuration can stably form the film with better in-plane uniformity of the film thickness.

In this time, in the film-forming apparatus, the inner face of the ceiling of the film-forming chamber and the substrate-placing face of the substrate-placing member may be in parallel.

This configuration can stably form the film with better in-plane uniformity of the film thickness.

In this time, in the film-forming apparatus, a difference in a height position between the inner face of the ceiling of the film-forming chamber and a surface to be treated of the substrate placed on the substrate-placing member may be 0.1 cm or longer and 6.0 cm or shorter.

This configuration can stably form the film with better in-plane uniformity of the film thickness.

In this time, in the film-forming apparatus, when an area of a surface to be treated of the substrate is A [cm²] and an area of the inner face of the ceiling of the film-forming chamber is B [cm²], A and B may satisfy B/A≥1.0.

This configuration can stably form the film with better in-plane uniformity of the film thickness.

In this time, in the film-forming apparatus, a shortest distance between an inner face of a side wall of the film-forming chamber and a substrate-placing region of the substrate-placing member may be 5.0 cm or shorter.

This configuration can further stably form the film with further better in-plane uniformity of the film thickness.

In this time, in the film-forming apparatus, the gas-discharging member may be provided in a pair of directions of the film-forming chamber opposite to each other.

This configuration can stably form the film with better in-plane uniformity of the film thickness.

In this time, the film-forming apparatus may further comprise a moving mechanism to move the substrate under the nozzle.

This configuration can form the film with good in-plane uniformity of the film thickness with a large area.

In this time, in the film-forming apparatus, the raw material solution may contain gallium.

This configuration can form a gallium oxide film with good in-plane uniformity of the film thickness.

In this time, in the film-forming apparatus, the raw material solution may contain a halogen.

This configuration can form a crystalline oxide film with good in-plane uniformity of the film thickness.

The present invention has been made to achieve the above object. The present invention provides a film-forming method of thermally treating an atomized raw material solution and forming a film on a substrate, the method comprising: a mist-generating step of atomizing the raw material solution into a mist; a mist-carrying step of carrying the mist with a carrier gas toward a film-forming chamber; and a film-forming step of supplying and thermally treating the mist onto the substrate placed on a substrate-placing member in the film-forming chamber, and forming a film, wherein in the used film-forming chamber, a difference in a height position between an inner face of a ceiling of the film-forming chamber and a substrate-placing face of the substrate-placing member is set to 0.15 cm or longer and 6.05 cm or shorter, and in the film-forming step, the mist is supplied between the ceiling of the film-forming chamber and the substrate through a nozzle provided above the substrate-placing member, and an exhaust gas is discharged from above the substrate in the film-forming chamber toward an outside of the film-forming chamber to form a film while supplying the rectified mist onto the substrate.

According to such a film-forming method, the film with good in-plane uniformity of the film thickness can be formed. A synergistic effect of a rectifying effect by the ceiling of the film-forming chamber and convection generated by supplying the mist through the nozzle and discharging the exhaust gas through gas-discharging member generates uniform gas flow above the substrate along the substrate (parallel to the substrate surface) to form the uniform film on the substrate.

In this time, in the used film-forming chamber in the film-forming method, the inner face of the ceiling of the film-forming chamber and an opening face of the nozzle may be set to be present in an identical plane.

This configuration can stably form the film with better in-plane uniformity of the film thickness.

In this time, in the used film-forming chamber in the film-forming method, the inner face of the ceiling of the film-forming chamber and the substrate-placing face of the substrate-placing member may be set to be in parallel.

This configuration can stably form the film with better in-plane uniformity of the film thickness.

In this time, in the used film-forming chamber in the film-forming method, a difference in a height position between the inner face of the ceiling of the film-forming chamber and a surface to be treated of the substrate placed on the substrate-placing member may be set to 0.1 cm or longer and 6.0 cm or shorter.

This configuration can stably form the film with better in-plane uniformity of the film thickness.

In this time, in the used film-forming chamber in the film-forming method, when an area of the substrate is A [cm²] and an area of the inner face of the ceiling of the film-forming chamber is B [cm²], A and B may be set to satisfy B/A≥1.0.

This configuration can stably form the film with better in-plane uniformity of the film thickness.

In this time, in the used film-forming chamber in the film-forming method, a shortest distance between an inner face of a side wall of the film-forming chamber and a substrate-placing region of the substrate-placing member may be set to 5.0 cm or shorter.

This configuration can further stably form the film with further better in-plane uniformity of the film thickness.

In this time, in the film-forming step in the film-forming method, the exhaust gas may be discharged in a pair of directions of the film-forming chamber opposite to each other.

This configuration can stably form the film with better in-plane uniformity of the film thickness.

In this time, in the film-forming method, when a flow rate of the carrier gas supplied thorough the nozzle is Q [L/min] and a flow rate of the exhaust gas is E [L/min], E/Q may be set to 5.0 or less.

This configuration can form the film with further better in-plane uniformity of the film thickness.

In this time, in the film-forming step in the film-forming method, the substrate may be moved under the nozzle.

This configuration can form the film with good in-plane uniformity of the film thickness with a large area.

In this time, in the film-forming method, the used raw material solution may contain gallium.

This configuration can form a gallium oxide film with good in-plane uniformity of the film thickness.

In this time, in the film-forming method, the used raw material solution may contain a halogen.

This configuration can form a crystalline oxide film with good in-plane uniformity of the film thickness.

In this time, in the film-forming method, a substrate having an area of a surface to be treated of 50 cm² or more or having a diameter of 4 inch (100 mm) or longer may be used as the substrate.

This configuration can form the film with good in-plane uniformity of the film thickness with a large area.

### ADVANTAGEOUS EFFECTS OF INVENTION

As noted above, according to the film-forming apparatus of the present invention, the film with good in-plane uniformity of the film thickness can be formed on the substrate by using the mist raw material solution. According to the film-forming method of the present invention, the film with good in-plane uniformity of the film thickness can be formed on the substrate by using the mist raw material solution.

### BRIEF DESCRIPTION OF DRAWINGS

FIG. 1 is a schematic structural view illustrating an example of a film-forming apparatus of the present invention;
FIG. 2 is a view describing an example of a mist-generating member according to the present invention;
FIG. 3 is a view describing an example of a film-forming chamber according to the present invention;
FIG. 4 is a view describing an example of a nozzle according to the present invention;
FIG. 5 is a view describing an example of a case of a plurality of the nozzles;
FIG. 6 is a view describing an example of a nozzle having a plurality of nozzle opening faces;
FIG. 7 is a view describing an example of a film-forming chamber according to the present invention;
FIG. 8 is a view describing an example of a film-forming chamber according to the present invention;
FIG. 9 is a view describing an example of a moving mechanism reciprocating under a nozzle;
FIG. 10 is a view describing an example of a moving mechanism rotationally moving in one direction under a nozzle;
FIG. 11 is a view describing an example of a gas-discharging member according to the present invention;
FIG. 12 is a view describing an example of a film-forming apparatus used in Comparative Example 1;
FIG. 13 is a view describing an example of a film-forming apparatus used in Comparative Example 2;
FIG. 14 is a view describing an example of a film-forming apparatus used in Comparative Example 3; and
FIG. 15 is a view describing an example of a film-forming apparatus used in Example 12.

### DESCRIPTION OF EMBODIMENTS

Hereinafter, the present invention will be described in detail, but the present invention is not limited thereto.

As noted above, the film-forming apparatus and film-forming method that can form a film with good in-plane uniformity of the film thickness have been required for the mist CVD.

The present inventors have earnestly studied the above problem, and consequently found that the film with good in-plane uniformity of the film thickness can be formed with a film-forming apparatus comprising: a mist-generating member to atomize a raw material solution into a mist; a carrier gas-supplying member to supply a carrier gas for carrying the mist generated in the mist-generating member; and a film-forming member to thermally treat the mist carried with the carrier gas to form a film, wherein the film-forming member comprises: a film-forming chamber; a substrate-placing member provided inside the film-forming chamber; a nozzle to supply the mist toward the inside of the film-forming chamber; and a gas-discharging member to discharge an exhaust gas from the inside to an outside of the film-forming chamber, and a difference in a height position between an inner face of a ceiling of the film-forming chamber and a substrate-placing face of the substrate-placing member is 0.15 cm or longer and 6.05 cm or shorter. This finding has led to completion of the present invention.

The present inventors also have found that the film with good in-plane uniformity of the film thickness can be formed by a film-forming method of thermally treating an atomized raw material solution and forming a film on a substrate, the method comprising: a mist-generating step of atomizing the raw material solution into a mist; a mist-carrying step of carrying the mist with a carrier gas toward a film-forming chamber; and a film-forming step of supplying and thermally treating the mist onto the substrate placed on a substrate-placing member in the film-forming chamber, and forming a film, wherein in the used film-forming chamber, a difference in a height position between an inner face of a ceiling of the film-forming chamber and a substrate-placing face of the substrate-placing member is set to 0.15 cm or longer and 6.05 cm or shorter, and in the film-forming step, the mist is supplied between the ceiling of the film-forming chamber and the substrate through a nozzle provided above the substrate-placing member, and an exhaust gas is discharged from above the substrate in the film-forming chamber toward an outside of the film-forming chamber to form a film while supplying the rectified mist onto the substrate. This finding has led to completion of the present invention.

Hereinafter, the description will be made with reference to the drawings.

The term "mist" in the present invention generally refers to fine liquid particles dispersed in gas, and encompasses materials called fog, droplet, etc.

### Film-Forming Apparatus

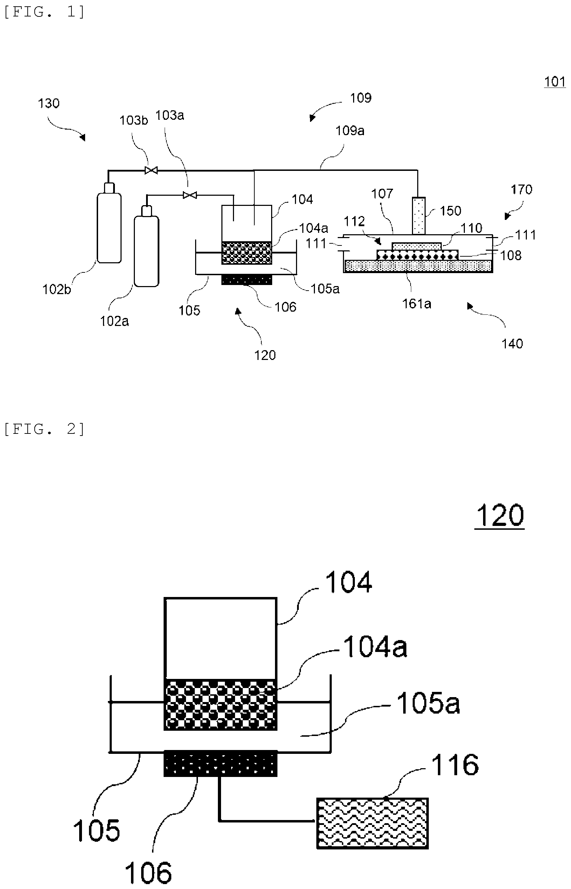

FIG. 1 illustrates an example of a film-forming apparatus 101 according to the present invention. The film-forming apparatus 101 has: a mist-generating member 120 to atomize a raw material solution into a mist; a carrier gas-supplying member 130 to supply a carrier gas for carrying the mist; and a film-forming member 140 to thermally treat the mist to form a film on a substrate; a carrying member 109 to connect the mist-generating member 120 and the film-forming member 140, and to carry the mist with the carrier gas; and a gas-discharging member 170 to discharge an exhaust gas from the film-forming chamber 107. The film-forming apparatus 101 may have a controlling member (not illustrated) to control an entirety or part of the film-forming apparatus 101 to control the operation.

### (Mist-Generating Member)

The mist-generating member 120 atomizes the raw material into a mist. The mist-generating means is not particularly limited as long as the means can atomize the raw material solution into a mist. The mist-generating means may be a known means, but a mist-generating means with ultrasonic vibration is preferably used. This is because of more stable mist generation.

FIG. 2 illustrates an example of the mist-generating member 120 as above. For example, the mist-generating member 120 may have: a mist-generating source 104 to contain a raw material solution 104a; a container 105 that can contain a medium that can propagate the ultrasonic vibration, for example, water 105a; and an ultrasonic vibrator 106 attached to a bottom of the container 105. In detail, the mist-generating source 104 composed of the container containing the raw material solution 104a is contained in the container 105 containing water 105a by using a support (not illustrated). The ultrasonic vibrator 106 is attached on the bottom of the container 105, and the ultrasonic vibrator 106 and an oscillator 116 are connected. The mist-generating member 120 is configured such that when the oscillator 106 is operated, the ultrasonic vibrator 106 vibrates to propagate ultrasonic wave in the mist-generating source 104 via water 105a, and to atomize the raw material solution 104a into a mist.

### (Carrier Gas-Supplying Member)

The carrier gas-supplying member 130 has a carrier gas source 102a to supply the carrier gas (main carrier gas), and may have a flow-rate regulating vent 103a to regulate a flow rate of the main carrier gas fed from the carrier gas source 102a. As necessary, the carrier gas-supplying member 103 may have: a dilution carrier gas source 102b to supply a carrier gas for dilution (dilution carrier gas); and a flow-rate regulating vent 103b to regulate a flow rate of the dilution carrier gas fed from the dilution carrier gas source 102b.

A type of the carrier gas is not particularly limited, and may be appropriately selected depending on a material to be formed. Examples thereof include oxygen, ozone, an inert gas such as nitrogen and argon, and a reductive gas such as hydrogen gas and forming gas. A number of types of the carrier gas may be one, or two or more. For example, a diluted gas in which a gas same as a first carrier gas is diluted with another gas (for example, diluted to 10 times) may be further used as a second carrier gas, and air may also be used. A number of positions for supplying the carrier gas is not limited to only one, and may be two or more.

### (Film-Forming Member)

The film-forming member 140 has: a film-forming chamber 107; a substrate-placing member 112 provided inside the film-forming chamber 107; a nozzle 150 to supply the mist toward the inside of the film-forming chamber 107; and a gas-discharging member 170 to discharge an exhaust gas from the inside to an outside of the film-forming chamber 107.

In the film-forming member 140, the mist is heated to cause a thermal reaction, and the film is formed on a part or entirety of a surface of a substrate 110. The film-forming member 140 has the film-forming chamber 107 surrounding a part or entirety of the film-forming member 140. For example, an entirety or part of the film-forming member 140 may be surrounded to configure the film-forming chamber 107, as illustrated in FIG. 1. The film-forming chamber 107 may not have a totally surrounding shape but have a discharging port 111 to discharge the exhaust gas generated in the film-forming chamber to be a structure that can discharge the mist or the carrier gas supplied above the substrate while rectifying.

The film-forming member 140 has the substrate-placing member 112 on which the substrate 110 is to be placed. The film-forming member 140 may have a hotplate 108 to heat the placed substrate 110. The hotplate 108 may be provided inside the film-forming chamber 107 as illustrated in FIG. 1, or may be provided outside the film-forming chamber 107.

The film-forming chamber in the present invention refers to a configuration having: a bottom wall having a bottom face parallel to the substrate-placing face on which the substrate is to be placed; a ceiling being an upper wall having a face (inner face of the film-forming chamber) intersecting with a normal line of the substrate-placing face; and a side wall having at least one or more side faces (inner faces) contacting with the bottom wall. In this case, the film-forming chamber may have a form such as: a cubic, cuboid, or pillar shape having the inner face of the ceiling being parallel to the substrate-placing face and having a side face perpendicular to the inner face of the ceiling and the bottom face; or a form with integrated ceiling and a side wall by setting a curved inner face of the ceiling (namely a dome shape). The film-forming chamber may have a structure of a combination thereof, but preferably has good symmetry because of the good in-plane uniformity of the film thickness. The film-forming chamber according to the present invention may be a film-forming chamber with a set and formed structure in advance, or may have a shape settable for a purpose by designing each member to constitute the film-forming chamber to be movable.

The ceiling in the present invention refers to an upper wall having a face (which may be referred to as "ceiling face") intersecting a normal line of the substrate-placing face of the film-forming chamber 107.

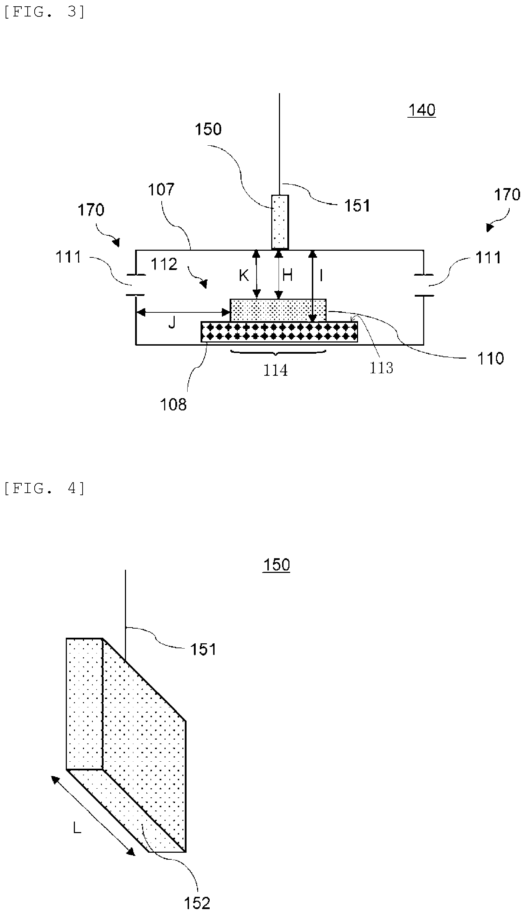

The film-forming chamber 107 has the gas-discharging member 170 as in FIG. 3, and a difference I [cm] in a height position between the substrate-placing face 113 and the inner face of the ceiling of the film-forming chamber is 0.15 cm or longer and 6.05 cm or shorter, and preferably 0.25 cm or longer and 3.05 cm or shorter. The film-forming chamber set and provided as above hardly disturbs a flow of the mist due to a flow of a circumambient gas with thermal convection during the film-forming treatment with a thermal treatment, and the mist supplied through a nozzle 150 is rectified and supplied onto the substrate 110 to form the film with excellent in-plane uniformity of the film thickness.

That is, the mist supplied through the nozzle 150 to the inside of the film-forming chamber 107 passes between: the ceiling of the film-forming chamber 107; and the substrate-placing face 113 of the substrate-placing member 112 and the substrate 110 on the substrate-placing face 113. The mist is rectified so as to flow in a direction of the gas-discharging member 170 to uniformize the flow rate and direction of the mist.

The inner face of the ceiling of the film-forming chamber 107 and the substrate-placing face are preferably parallel to each other. Further, when the substrate is placed on the substrate-placing member 112, a difference K in a height position between the inner face of the ceiling of the film-forming chamber 107 and the surface to be treated of the substrate 110 is preferably 0.1 cm or longer and 6.0 cm or shorter, and more preferably 0.2 cm or longer and 3.0 cm or shorter. This is because the film to be formed has further better in-plane uniformity of the film thickness.

On the film-forming member 140, the nozzle 150 to supply the mist toward the substrate 110 in the film-forming chamber 107 is provided above the substrate-placing member 112 as illustrated in FIG. 3. The nozzle 150 in the present invention refers to a member to supply the mist toward the inside of the film-forming chamber 107. For example, a supplying tube 109a of the carrying member 109, described later, may be connected to the film-forming chamber 107 etc. to use the supplying tube 109a as the nozzle.

FIG. 4 illustrates an example of the nozzle 150. The nozzle 150 has: a connecter 151 to connect the carrying member 109 and the nozzle 150; and a nozzle opening face (which may be simply referred to as "opening face") 152 to jet the mist.

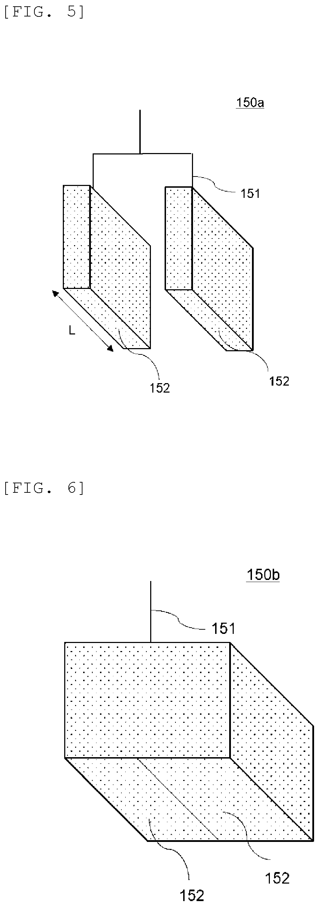

A number of the nozzles and a number of the opening faces are not particularly limited as long as the numbers are one or more. A plurality of the nozzles may be provided (nozzles 150a) as illustrated in FIG. 5, and a plurality of the opening faces may be present (nozzle 150b) as illustrated in FIG. 6.

An angle formed by a plane including the nozzle opening face 152 and a plane including the substrate 110 is not particularly limited. A nozzle having a nozzle opening face tilted so that the mist easily flows in a specific direction may be provided, but as illustrated in FIG. 3, the substrate-placing face 113 of the substrate-placing member 112 on which the substrate 110 is to be placed and the nozzle opening face are preferably provided so as to be parallel to each other. This is because the film with better in-plane uniformity of the film thickness can be formed with the simpler structure.

The film-forming member 140 may have a position-adjusting mechanism (not illustrated) such that the difference H [cm] in the height position between the nozzle opening face 152 and the surface to be treated of the substrate 110 can be appropriately adjusted within a range described later.

The ceiling of the film-forming chamber 107 has a hole to supply the mist through the nozzle 150 (namely, a donut shape), or the film-forming chamber 107 has a structure formed by combining a plurality of members to be able to form a hole on the ceiling of the film-forming chamber 107. The nozzle is inserted through this hole. The structure formed by combining a plurality of members is preferable because a size of the hole on the ceiling of the film-forming chamber 107, the above differences H, I, and K [cm], and a shortest distance J [cm] between an inner face of a side wall of the film-forming chamber 107 and the substrate-placing region 114, described later, can be appropriately adjusted depending on an area of the nozzle opening face.

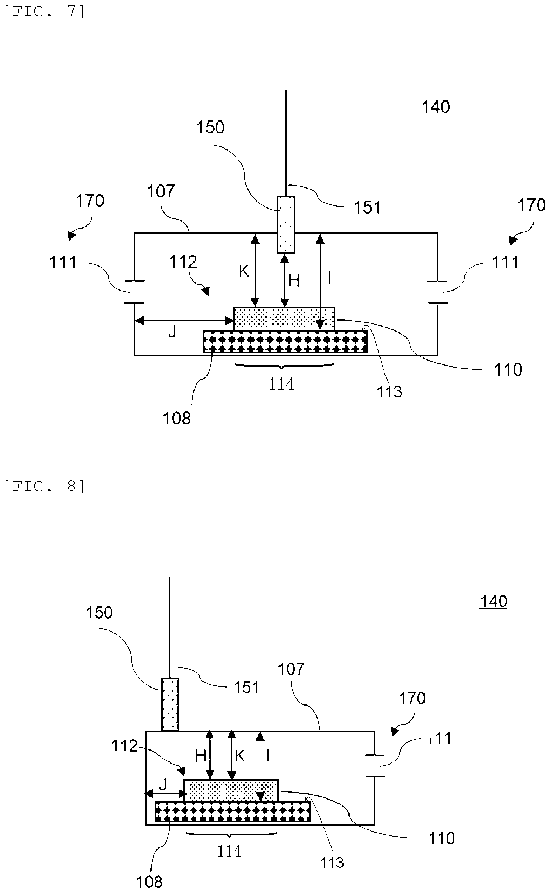

The height position of the nozzle opening face may be the height position same as the ceiling of the film-forming chamber 107 as in FIGS. 3 and 8, or may be a position lower than the ceiling of the film-forming chamber 107 as in FIG. 7. The inner face of the ceiling of the film-forming chamber and the nozzle opening face 152 are preferably present on an identical plane as illustrated in FIGS. 3 and 8. This is because, when the nozzle opening face is present on the same height as the ceiling of the film-forming chamber 107, the rectifying effect by the ceiling is more effectively exhibited to more stably improve the in-plane uniformity of the film thickness. In this case, H=K as illustrated in FIGS. 3 and 8.

The nozzle 150 may have a structure formed by assembling a plurality of members to have a structure such that an area S [cm²] of the nozzle opening face can be appropriately adjusted by adjusting the sizes of the members.

In this case, the area S of the nozzle opening face 152 is preferably 0.1 cm² or more and 400 cm² or less. The difference H in the height position between the nozzle opening face 152 and the surface to be treated of the substrate 110 is favorably 0.1 cm or longer and 6.0 cm or shorter, and more preferably 0.2 or longer and 3.0 or shorter. This is because the film to be formed has further better in-plane uniformity of the film thickness.

When an area of the nozzle opening face 152 is S [cm²] and an area of the surface to be treated of the substrate is A [cm²], S and A preferably satisfy S/A≤0.3, and more preferably satisfy 0.004≤S/A≤0.15. Setting to S/A≤0.3 yields the film with better in-plane uniformity of the film thickness. In this time, the area A of the substrate is preferably 10 cm² or more, and more preferably 50 cm² or more. The diameter is preferably 4 inch (100 mm) or more, and an upper limit thereof is not particularly limited. A larger area of the substrate can yield the film with a larger area with one time film formation, and thereby suitable for mass production of the semiconductor devices.

The nozzle 150 may have a temperature-regulating mechanism (not illustrated) to regulate a temperature on an outer surface of the nozzle 150 or a temperature of an inner surface of the nozzle 150. If the temperature of the inner or outer surface is excessively high, evaporation of the mist is promoted to increase the film thickness at a position on the substrate distanced from the nozzle opening face. If the temperature is excessively low, evaporation of the mist becomes slow to decrease the film thickness at a position near the nozzle opening face. The temperature is preferably regulated within approximately 40 to 120°C. Regulating the H varies a distance with the hotplate 108, and thereby the temperature of the nozzle 150 varies. Thus, the temperature-regulating mechanism other than the hotplate 108 is preferably provided. The temperature-regulating mechanism may be: a mechanism in which a pipe is provided around the nozzle 150, etc. to exchange heat by using a liquid or gas heating medium; a mechanism of applying a Peltier effect; or heating with a ribbon heater, etc. As the heating medium, known heating media may be widely used, and for example, liquid heating media such as water, glycols, alcohols, and silicone oils, and gas heating media such as air, nitrogen, helium, and fluorocarbons are suitably used.

A shape of the nozzle opening face 152 is not particularly limited. The shape may be polygonal, circular, oval, etc., preferably quadrangular, and more preferably rectangular. When the nozzle opening face 152 has the rectangular shape, a longitudinal length of the nozzle opening face 152, L [cm], and a maximum length in a nozzle longitudinal direction of the substrate, R [cm], preferably satisfy L/R≥1. This is because the condition L/R≥1 can form the film with good in-plane uniformity of the film thickness on a large-area substrate. An upper limit of L/R is not particularly limited, but preferably 3 or less because a larger L/R causes a larger amount of the mist not supplied onto the substrate.

An angle formed by the inner face of the ceiling of the film-forming chamber 107 and the substrate 110, and an angle formed by the inner face of the ceiling of the film-forming chamber 107 and the nozzle opening face 152 are not particularly limited, but both the members are preferably in parallel. This is because the film with better in-plane uniformity of the film thickness can be formed with a simpler structure.

A shape of the ceiling of the film-forming chamber 107 may be tetrahedral, semicircular, circular, or oval, and preferably quadrangular or circular. This is because the good symmetry yields the formed film to have good in-plane uniformity of the film thickness.

A part or entirety of the ceiling of the film-forming chamber 107 may be curved or bent so that the mist easily flows in a specific direction, but the ceiling is preferably provided to be parallel to the substrate-placing member 112 as in FIG. 3. More specifically, the film-forming chamber 107 is preferably provided so that the substrate-placing face 113 of the substrate-placing member 112 on which the substrate 110 is to be formed and the inner face of the ceiling of the film-forming chamber 107 are parallel to each other. This is because the film to be formed has good in-plane uniformity of the film thickness.

A material of the film-forming chamber 107 is not particularly limited. The material may be polysulfone, polyether sulfone, polyphenylene sulfide, polyether ether ketone, polyimide, polyether imide, a fluororesin, metals such as iron, aluminum, stainless steel, and gold, quartz, glass, or boron nitride. Since deformation in the thermal treatment deteriorates the in-plane uniformity of the film thickness, metals such as iron, aluminum, stainless steel, and gold, quartz, boron nitride, etc. are preferably used.

The film-forming chamber 107 may have a temperature-regulating mechanism (not illustrated) that can regulate a temperature on the wall face of the film-forming chamber. If the temperature on the wall face is excessively high, evaporation of the mist is promoted to decrease the film thickness at a position on the substrate distanced from the nozzle opening face. If the temperature is excessively low, evaporation of the mist becomes slow to decrease the film thickness at a position on the substrate near the nozzle opening face. The temperature is preferably regulated within approximately 40 to 120°C.

The substrate-placing member 112 may not be provided at a center of the film-forming chamber 107 as in FIG. 8, and a distance between an inner face other than the ceiling of the film-forming chamber 107 and the substrate-placing region 114 may be different from the inner face (side face of each side wall) provided around the substrate-placing member 112. Here, a shortest distance between the inner face of the side wall of the film-forming chamber 107 and the substrate-placing region 114 of the substrate-placing member 112 is defined as J [cm].

The shortest distance J [cm] (see FIGS. 3, 7, and 8) is not particularly limited, but preferably 5 cm or shorter, may be 0 cm (that is, the members are contacted with each other), and more preferably 0.5 cm or longer and 4 cm or shorter. When J is within such a range, the mist spread sideward can be effectively inhibited, and thereby the mist is stably supplied onto an edge of the substrate 110 to inhibit deterioration of the in-plane uniformity of the film thickness, and can stably inhibit decrease in the mist supplied on the substrate edge due to friction with the wall face of the film-forming chamber 107, which occurs with a small J, to inhibit decrease in the film thickness.

The inner face of the side wall of the present invention refers to a face contacted with a bottom face parallel to the substrate-placing face of the substrate-placing member 112 of the film-forming chamber 107.

When an area of the inner face of the ceiling of the film-forming chamber 107 (a total area including the nozzle opening face 152) is B [cm²] and an area of the surface to be treated of the substrate is A [cm²], A and B favorably satisfy B/A≥1.0, preferably 3.0 or more, and more preferably 5.0 or more. This is because the mist flow near the substrate is hardly disturbed by the thermal convection. B is preferably 100 or more. With such a numerical range, the film having further excellent in-plane uniformity of the film thickness is formed. Upper limits of B/A and B are not particularly limited. This is because values larger than the above values exhibit the rectifying effect by the ceiling of the film-forming chamber 107. However, B/A is preferably 100 or less. This is because of inhibition of increase in size of the apparatus more than necessary.

The film-forming chamber 107 may have a temperature-regulating mechanism (not illustrated) that can regulate a temperature on the inner face of the ceiling and the inner face of the side wall. If the surface temperature is excessively high, evaporation of the mist is promoted to increase the film thickness at a position on the substrate distanced from the nozzle opening face. If the temperature is excessively low, evaporation of the mist becomes slow to decrease the film thickness at a position near the nozzle opening face. The temperature is preferably regulated within approximately 40 to 120°C. The temperature-regulating mechanism may be: a mechanism to exchange heat by using a liquid or gas heating medium; a mechanism of applying a Peltier effect; or heating with a ribbon heater, etc. As the heating medium, known heating media may be widely used, and for example, liquid heating media such as water, glycols, alcohols, and silicone oils, and gas heating media such as air, nitrogen, helium, and fluorocarbons are suitably used.

The film-forming member 140 may have a moving mechanism such as a movable stage 161a to move the substrate 110 under the nozzle 150, as illustrated in FIG. 1. A direction in which the substrate is moved is not particularly limited.

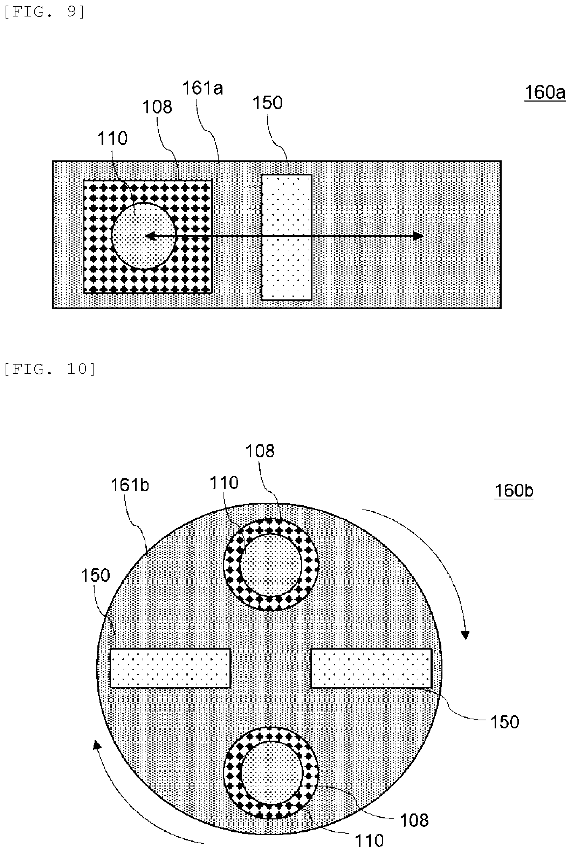

FIGS. 9 and 10 are views illustrating an inside of the film-forming chamber 107 having the moving mechanism viewed from above of the substrate-placing member. In one method, as illustrated with the moving mechanism 160a in FIG. 9, the movable stage 161a mounting the substrate 110 and the hotplate 108 is provided, and the substrate 110 and the hotplate 108 reciprocate under the nozzle 150. In another method, as illustrated with a moving mechanism 160b in FIG. 10, the movable stage 161b mounting the substrate 110 and the hotplate 108 rotationally moves the substrate 110 and the hotplate 108 under the nozzle 150. In this case, a mechanism such that the substrate rotates may be provided to allow the substrate to rotate.

A plurality of substrates 110 and nozzles 150 may be mounted on the film-forming member 140 as in FIG. 10, and a plurality of the substrates may be provided in the film-forming member 140 in FIG. 9, etc. With such structures, films can be formed on many substrates one time while keeping the in-plane uniformity of the film thickness, and thereby furthermore suitable for mass production.

When the moving mechanism 160 for the substrate is provided, a speed for moving the substrate and moving range are not particularly limited, but a number of times at which one substrate passes under the nozzle is favorably 0.1 or more, preferably 0.5 or more, and more preferably 1 or more per minute. The number of times of 0.1 or more can prevent inhibition of exhibiting the rectifying effect by the top plate due to the significant effect on the supplying gas derived from an upward current with local evaporation of the mist, which can more certainly prevent decrease in uniformity of the film thickness. An upper limit of the number of times is not particularly limited, but favorably 120 or less, and preferably 60 or less because increase in the number of times destabilizes fixing of the substrate due to an inertia force.

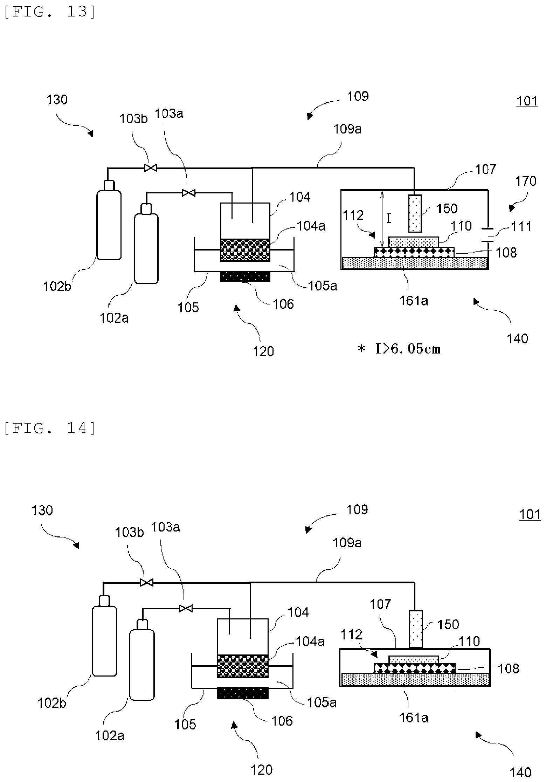

More specifically, in a case of the moving mechanism as in FIG. 13, v/D [/min], which is a moving speed "v" [mm/min] of the substrate relative to a width D [mm] with which the substrate moves, is favorably 0.1 or more, preferably 0.5 or more and 120 or less, and more preferably 1 to 60. D is not particularly limited, and for example, favorably equal to or longer than a diameter [mm] of the substrate (100 or longer when the substrate has a diameter of 4 inch), and the upper limit is not particularly limited. Setting D to be larger can form a film on a larger number of the substrates with one nozzle. However, such a larger D decreases a film-forming rate per substrate, and thereby it is preferable that D is set to 1000 mm or shorter to limit a number of the substrates for forming the film with one nozzle, which yields furthermore excellent productivity. "v" is not particularly limited. "v" is favorably 10 mm/min or more and 30000 mm/min or less, preferably 30 mm/min or more and 12000 mm/min, and more preferably 60 mm/min or more and 6000 mm/min or less. In a case of the rotary moving mechanism as in FIG. 14, a number of rotation is favorably 0.1 rpm or more, preferably 0.5 to 120 rpm, and more preferably 1 to 60 rpm.

### (Gas-Discharging Member)

The film-forming chamber 107 has a gas-discharging member 170 such that the mist supplied onto the substrate 110 together with the carrier gas is used for forming the film, and the produced gas (also referred to as "exhaust gas", including the mist not used for forming the film, a gas generated during the film formation, the carrier gas, etc.) is rectified for flowing toward an outside of the substrate 110. The exhaust gas is discharged from the film-forming chamber 107 through this gas-discharging member 170.

A shape and configuration of the gas-discharging member 170 are not particularly limited as long as the configuration can discharge the exhaust gas from the substrate 110 toward the outside of the substrate 110. For example, a discharging port 111 may be provided on a side of the substrate 110 in the film-forming chamber 107 as in FIG. 1 to perform forced discharge. Particularly preferable is a configuration such that the carrier gas etc. supplied through the nozzle 150 between the ceiling and the substrate 110 in the film-forming chamber 107 flow toward the outside of the substrate 110. The outside of the substrate 110 described herein refers to a region excluding a space formed by the substrate surface in a normal direction of the surface.

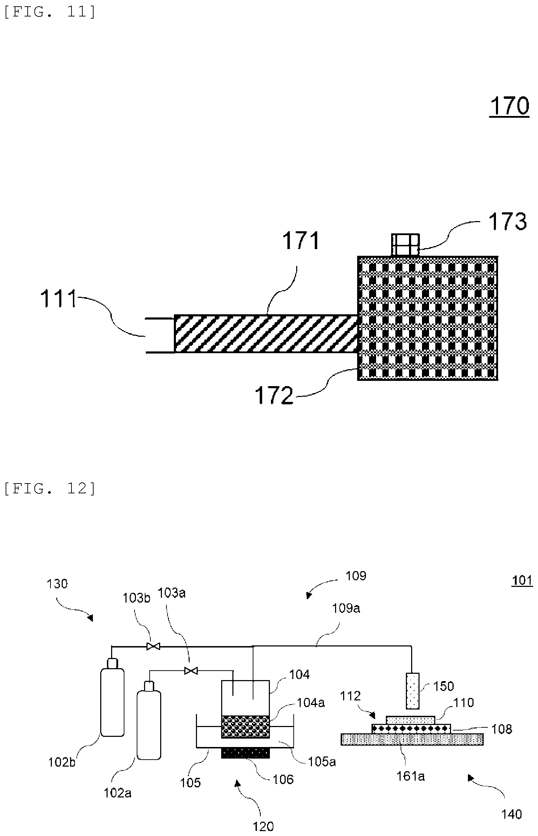

The gas-discharging member 170 may be the discharging port 111 itself provided on the film-forming chamber 107 as note above, or may have a configuration in which a means for forced discharge is added onto the discharging port 111. FIG. 11 illustrates an example of such a gas-discharging member 170. For example, the gas in the film-forming chamber 107 is forcedly discharged from the discharging port 111 provided on the side face of the film-forming chamber 107 through a gas-discharging duct 171 by a gas-discharging unit 172 provided outside the film-forming chamber 107. The gas-discharging unit 172 has a gas-discharging flow-rate regulating vent 173 for regulating the discharged gas flow rate, which can regulate the discharged gas flow rate.

By a synergistic effect of the rectifying effect by the ceiling of the film-forming chamber 107 provided at the height position as note above and the convection generated by supplying the mist through the nozzle 150 and discharging the exhaust gas from the gas-discharging member 170, the uniform gas flow parallel to the surface of the substrate 110 above the substrate 110 is generated to form the uniform film on the substrate 110.

A shape of the discharging port 111 is not particularly limited such as circular and rectangular shapes, but preferably a symmetric structure in a direction perpendicular to the gas-flowing direction. This is because the good symmetry yield the good in-plane uniformity of the film thickness.

The gas-discharging member 170 may be provided at one position as in FIG. 8, or may be provided at two or more positions as in FIGS. 1, 3, and 7. When provided at two or more positions, the gas-discharging members are preferably provided in a pair of directions opposite to the film-forming chamber, and more preferably provided at a symmetric position relative to the center of the nozzle opening face. This is because the film with good in-plane uniformity of the film thickness can be formed.

The gas-discharging member 170 may have a temperature-regulating mechanism (not illustrated) to regulate a temperature of a part or entirety of the gas-discharging member so as to inhibit solid precipitation therein. Such a temperature-regulating mechanism inhibits solid precipitation in the gas-discharging member 170 to more easily regulate a flow rate of the discharge.

The temperature-regulating mechanism may be: a mechanism in which a pipe, etc. is provided around the gas-discharging duct 171, etc. to exchange heat by using a liquid or gas heating medium; a mechanism of applying a Peltier effect; or heating with a ribbon heater, etc. As the heating medium, known heating media may be widely used, and for example, liquid heating media such as water, glycols, alcohols, and silicone oils, and gas heating media such as air, nitrogen, helium, and fluorocarbons are suitably used.

A material of the member to constitute the gas-discharging member 170 is not particularly limited. The material may be polysulfone, polyether sulfone, polyphenylene sulfide, polyether ether ketone, polyimide, polyether imide, a fluororesin, metals such as iron, aluminum, stainless steel, and gold, quartz, boron nitride, etc. The gas-discharging member 170 is preferably made of boron nitride. This is because boron nitride can inhibit rusting due to an unintended reaction with an unreacted raw material and solid precipitation to cause nonuniformity of the flow of the exhaust gas.

When the film-forming chamber 107 has the moving mechanisms 160a and 160b as described above, the discharging port 111 may be provided above the moving mechanisms 160a and 160b to move the discharging port 111 (gas-discharging member 170).

### (Carrying Member)

The carrying member 109 connects the mist-generating member 120 and the film-forming member 140. The mist is carried with the carrier gas from the mist-generating source 104 of the mist-generating member 120 through the carrying member 109 toward the nozzle 150 of the film-forming member 140. The carrying member 109 may be a supplying tube 109a, for example. For the supplying tube 109a, a quartz tube, a tube made of a resin, etc. may be used, for example.

### (Raw Material Solution)

The raw material solution 104a is not particularly limited as long as the solution contains a material that can be atomized into a mist, and the raw material solution may be an inorganic material or an organic material. For the raw material solution, a solution (such as an aqueous solution) of a metal or a metal compound is preferably used, and a solution containing one or two or more metals selected from gallium, iron, indium, aluminum, vanadium, titanium, chromium, rhodium, nickel, and cobalt may be used. In particular, a raw material solution containing gallium can yield an gallium oxide film with good in-plane uniformity of the film thickness.

The raw material solution is not particularly limited as long as the solution can atomize the metal solution into a mist, and as the raw material solution, a metal in a complex form or a salt form is dissolved or dispersed in an organic solvent or water can be preferably used. Examples of the complex form include an acetylacetonate complex, a carbonyl complex, an ammine complex, and a hydride complex. Examples of the salt form include a metal chloride salt, a metal bromide salt, and a metal iodide salt. In addition, the metal may be dissolved in hydrobromic acid, hydrochloric acid, hydroiodic acid, etc. for use as the aqueous solution of the salt. A concentration of the solute is preferably 0.01 to 1 mol/L.

Into the raw material solution, an additive containing a halogen (for example, a halogenated hydroacid), an oxidant, etc. may be mixed. Examples of the halogenated hydroacid include hydrobromic acid, hydrochloric acid, and hydroiodic acid. Among these, hydrobromic acid or hydroiodic acid is preferable. Examples of the oxidant include: peroxides such as hydrogen peroxide (H₂O₂), sodium peroxide (Na₂O₂), barium peroxide (BaO₂), and benzoyl peroxide (C₆H₅CO)₂O₂; hypochlorous acid (HClO), perchloric acid, nitric acid, ozone water, and organic peroxides such as peracetic acid and nitrobenzene. In particular, the raw material solution containing a halogen can yield a crystalline oxide film with good in-plane uniformity of the film thickness.

The raw material solution may further contain a dopant. The dopant is not particularly limited. Examples thereof include: n-type dopants such as tin, germanium, silicon, titanium, zirconium, vanadium, or niobium; and p-type dopants such as copper, silver, tin, iridium, and rhodium. A concentration of the dopant may be approximately 1.0×10⁻⁹ to 1.0 mol/L, may be as low as approximately 1.0×10⁻⁷ mol/L or less, or may be as high as approximately 0.01 mol/L or more.

### (Substrate)

The substrate 110 is not particularly limited as long as the substrate can provide film formation and can support the film. A material of the substrate 110 is also not particularly limited, and known substrates may be used. The material may be an organic compound or an inorganic compound. Examples thereof include polysulfone, polyether sulfone, polyphenylene sulfide, polyether ether ketone, polyimide, polyether imide, a fluororesin, metals such as iron, aluminum, stainless steel, and gold, quartz, glass, calcium carbonate, gallium oxide, and zinc oxide. In addition to the above, examples of the substrate also include single-crystal substrates made of silicon, sapphire, lithium niobate, lithium tantalate, SiC, GaN, iron oxide, chromium oxide, etc., and the single-crystal substrate as the above is desirable in the present invention. These single-crystal substrates can yield a crystalline oxide film with better quality. In particular, a sapphire substrate, a lithium tantalate substrate, and a lithium niobate substrate are relatively inexpensive and industrially advantageous. A thickness of the substrate is not particularly limited, and preferably 10 to 2000 um, and more preferably 50 to 800 um.

The film may be formed directly on the substrate, or may be stacked on an intermediate layer formed on the substrate. The intermediate layer is not particularly limited, and may mainly contain an oxide containing any one of, for example, aluminum, titanium, vanadium, chromium, iron, gallium, rhodium, indium, and iridium. More specific examples thereof include Al₂O₃, Ti₂O₃, V₂O₃, Cr₂O₃, Fe₂O₃, Ga₂O₃, Rh₂O₃, In₂O₃, and Ir₂O₃. When two elements selected from the aforementioned metal elements are A and B, the intermediate layer may be made of a binary metal oxide represented by (AₓB₁₋ₓ)₂O₃ (0<x<1), or when three elements selected from the aforementioned metal elements are A, B, and C, the intermediate layer may be made of a ternary metal oxide represented by (AlₓB_{y}C_{1-x-y})₂O₃ (0<x<1, 0<y<1).

The substrate 110 may have an area of the surface on which the film is to be formed of, for example, 10 cm² or more, more preferably 50 cm² or more, or may have a diameter of 4 inch (100 mm) or longer. Such a substrate is preferable because the film with good in-plane uniformity of the film thickness can be formed with a large area. An upper limit of the area or diameter of the substrate is not particularly limited, and may be an area of 750 cm² or a diameter of 300 mm.

### Film-Forming Method

Next, an example of the film-forming method according to the present invention will be described hereinafter with reference to FIG. 1. First, the raw material solution 104a is contained in the mist-generating source 104 of the mist-generating member 120, the substrate 110 such as the crystalline substrate is placed on the hotplate 108, and the hotplate 108 is operated.

Then, the flow-rate regulating vents 103a and 103b are opened to supply the main carrier gas from the carrier gas source 102a and the dilution carrier gas from the dilution carrier gas source 102b toward the inside of the film-forming chamber 107 to sufficiently replace an atmosphere in the film-forming chamber 107 with the carrier gas, and the flow rate of the main carrier gas and the flow rate of the dilution carrier gas are each regulated for control.

In the mist-generating step, the ultrasonic vibrator 106 is vibrated, and this vibration is propagated via water 105a through the raw material solution 104a to atomize the raw material solution 104a into a mist.

Then, in the mist-carrying step of carrying the mist with the carrier gas, the mist is carried with the carrier gas from the mist-generating member 120 through the carrying member 109 toward the film-forming member 140 to be introduced into the film-forming chamber 107.

In the film-forming step, the mist is supplied through the nozzle 150 provided above the substrate-placing member 112 (hotplate 108 on which the substrate 110 is placed) between the ceiling of the film-forming chamber 107 and the substrate 110. Then, the mist is rectified with the ceiling of the film-forming chamber 107 and exhaust gas from the gas-discharging member 170 (such as the discharging port 111) onto the substrate 110, and thermally treated to cause the thermal reaction by heat of the hotplate 108 in the film-forming chamber 107 and to form the film on the substrate 110.

In the film-forming method according to the present invention, the film with good in-plane uniformity of the film thickness can be formed by using the film-forming apparatus having the film-forming chamber set as described in the aforementioned film-forming apparatus, specifically such that the difference in the height position between the inner face of the ceiling of the film-forming chamber and the substrate-placing face of the substrate-placing member is 0.15 cm or longer and 6.05 cm or shorter. This is because the uniform gas flow along the substrate (parallel to the substrate surface) above the substrate is generated by the synergistic effect of the rectifying effect by the ceiling of the film-forming chamber and the convection generated by supplying the mist through the nozzle and discharging the exhaust gas, which can form the uniform film on the substrate.

The thermal reaction of the mist in the film-forming member 140 is a reaction of the mist by heating, and the reaction conditions etc. are not particularly limited. The reaction conditions etc. can be appropriately set according to the raw material and the film to be formed. For example, the heating temperature may be within a range of 120 to 600°C, preferably within a range of 200°C to 600°C, and more preferably within a range of 300°C to 550°C. When the heating temperature is T [°C], the area of the nozzle opening face 152 is S [cm²], and the flow rate of the carrier gas is Q [L/min], ST/Q is preferably 40 or more, and more preferably 100 or more and 2000 or less. ST/Q≥40 yields the film with better in-plane uniformity of the film thickness.

The thermal reaction may be performed under any of vacuum, a non-oxygen atmosphere, a reductive-gas atmosphere, an air atmosphere, and an oxygen atmosphere, which may be appropriately set according to the film to be formed. The reaction may be performed under any conditions of an atmospheric pressure, an increased pressure, and a reduced pressure, and the film formation under an atmospheric pressure is preferable because the apparatus configuration can be simplified.

The flow rate of the carrier gas is not particularly limited. For example, when the film is formed on a substrate with 4 inch (10 cm) in diameter, the flow rate is preferably 1 to 80 L/min, and more preferably 4 to 40 L/min. This flow rate Q of the carrier gas is a measured value at 20°C. When the flow rate is measured at another temperature or when a flow rate with another type (mass flow rate etc.) is measured, the result can be converted into the volume flow rate at 20°C by using the gas state equation.

The flow rate of the discharge is not particularly limited, but when the flow rate of the carrier gas supplied through the nozzle 150 is Q [L/min] and when the amount of discharge from the gas-discharging member 170 is E [L/min], E/Q is preferably 5.0 or less, and more preferably 0.5 or more and 3.0 or less. This is because of the good in-plane uniformity of the film thickness. In this time, E discharged from the gas-discharging member 170 can be calculated by multiplying: at 20°C, a linear rate measured at the discharging port 111 by using a flow meter or measured by using an anemometer; and an area of the opening face of the discharging port 111. When the wind speed is measured at another temperature or when the flow rate is measured by another method or at another temperature, the result can be converted into the volume flow rate at 20°C by using the gas state equation.

When the area of the nozzle opening face 152 is S [cm²], the flow rate of the carrier gas is Q [L/min], and a difference in height position between the nozzle opening face 152 and the surface to be treated of the substrate 110 (for example, a longest distance among distances between the nozzle opening face 152 and the surface of the substrate 110) is H [cm], SH/Q is favorably 0.015 or more, and preferably 0.1 or more and 20 or less. With SH/Q≥0.015, the film has better in-plane uniformity of the film thickness.

In this time, a rate of the gas on the nozzle opening face 152 in a direction perpendicular to the substrate is favorably 0.01 m/s or more and 8.0 m/s or less, and preferably 0.1 m/s or more and 2.0 m/s or less. The rate of the gas on the nozzle opening face 152 in a direction perpendicular to the substrate is calculated by dividing the flow rate Q [L/min] of the carrier gas by the area S [cm²] of the nozzle opening face 152, and converting the unit.

The film formation while moving the substrate 110 under the nozzle 150 by the moving mechanism 160 is effective for forming a film with a large area, and effective for forming an excellent film with furthermore excellent in-plane uniformity of the film thickness distribution.

Such a film-forming method can form the film with good in-plane uniformity of the film thickness of the substrate compared with the conventional methods.

In the present invention, an annealing treatment may be performed after the film formation. A temperature of the annealing treatment is not particularly limited, but preferably 600°C or lower, and more preferably 550°C or lower. This is not to impair crystallinity of the film. A treating time of the annealing treatment is not particularly limited, but preferably 10 seconds to 10 hours, and more preferably 10 seconds to 1 hour.

The crystalline oxide film, such as a semiconductor film, obtained by the film formation by the film-forming method according the present invention is a film with the excellent in-plane uniformity of the film thickness with a large area.

### EXAMPLE

Hereinafter, the present invention will be specifically described with Examples, but these Examples do not limit the present invention.

### (Example 1)

In the present Example, a film-forming apparatus as illustrated in FIG. 1 was used. A nozzle opening face 152 was fixed so as to have a plane identical to a ceiling of a film-forming chamber 107. When an area of the ceiling was B [cm²], B=600. A difference I in a height position between a substrate-placing face 113 (an upper face of a hotplate 108) of a substrate-placing member 112 and the ceiling of the film-forming chamber was I=2.05 cm.

Gallium iodide was added into water to be dissolved by stirring the mixture at 60°C for 60 minutes to prepare an aqueous solution at 0.1 mol/L, and this solution was used as a raw material solution 104a. The raw material solution 104a obtained as above was contained in a mist-generating source 104. A temperature of the solution at this time was 25°C.

Then, a c-face sapphire substrate with 4 inch (100 mm in diameter) as a substrate 110 was placed on the hotplate 108 in the film-forming chamber 107, and the hotplate 108 was operated to raise the temperature to 500°C.

Subsequently, flow-rate regulating vents 103a and 103b were opened for supplying nitrogen gas as a carrier gas from a carrier gas source 102a (main carrier gas) and a dilution carrier gas supplying source 102b for dilution carrier gas (dilution carrier gas) as carrier gases into the film-forming chamber 107 to sufficiently substitute atmosphere in the film-forming chamber 107 with these carrier gases, and a flow rate of the main carrier gas was set to 12 L/min and a flow rate of the dilution carrier gas was set to 12 L/min.

Subsequently, by using a gas-discharging member 170 as in FIG. 11, a gas-discharging flow rate regulating vent 173 was regulated so that a gas-discharging amount E [L/min] at a discharging port 111 was 24. At this time, E/Q=1.0.

Then, an ultrasonic vibrator 106 was vibrated at 2.4 MHz, and this vibration was propagated in the raw material solution 104a through water 105a to atomize the raw material solution 104a into a mist.

This mist was supplied onto the substrate 110 through a supplying tube 109a and a nozzle 150 with the carrier gas. As the nozzle 150, a nozzle in which the nozzle opening face 152 had a rectangular shape was used. When an area of the nozzle opening face 152 was S [cm²], when the flow rate of the carrier gas was Q [L/min], and when a difference in a height position between the nozzle opening face 152 and the substrate 110 (a longest distance among distances between points in the nozzle opening face 152 and the surface of the substrate 110) was H [cm], S, H, and Q were regulated so as to satisfy SH/Q=0.5. In this time, S=6.0 [cm²], H=2.0 [cm], and Q=24 [L/min].

Under an atmospheric pressure and a condition at 500°C, the mist was thermally reacted in the film-forming chamber 107 while discharging exhaust gas through the gas-discharging port 111 to form a thin film of gallium oxide (α-Ga₂O₃) having a corundum structure on the substrate 110. A time for the film formation was 300 minutes.

When the thermal-treating temperature was T [°C], ST/Q=125. When an area of the substrate was A [cm²], S/A=0.076. When a longitudinal length of the nozzle opening face 152 was L [cm] and when a maximum length in a nozzle longitudinal direction of the substrate was R [cm], L/R=1.2. In this time, T=500 [°C], A=78.5 [cm²], L=12 [cm], and R=10 [cm]. B/A=7.6.

With a movable stage 161a as in FIG. 13, the substrate and the hotplate was reciprocated at a rate of 15 [cm/min] so as to be passed under the nozzle once per minute.

### (Comparative Example 1)

The same manner was performed as in Example 1 except that a film-forming apparatus in which the film-forming chamber 107 was not provided as in FIG. 12 was used, and the time for the film formation was 60 minutes.

### (Comparative Example 2)

The same manner was performed as in Example 1 except that a film-forming apparatus in which the film-forming chamber 107 was provided as in FIG. 13 was used, and the difference I in the height position between the substrate-placing face 113 (the upper face of the hotplate 108) of the substrate-placing member 112 and the ceiling of the film-forming chamber 107 was set to I =15.05 cm.

### (Comparative Example 3)

The same manner was performed as in Example 1 except that a film-forming apparatus in which the gas-discharging member 170 was not provided on the film-forming chamber 107 as in FIG. 14 was used.

### (Example 2)

A film was formed in the same manner as in Example 1 except that the area S of the nozzle opening face 152 was changed to 2.4 [cm²], the difference H [cm] in the height position between the nozzle opening face 152 and the substrate 110 was changed to 6.0 [cm], the difference I in the height position between the ceiling of the film-forming chamber 107 and the substrate-placing face 113 of the substrate-placing member 112 was changed to 6.05 [cm], the flow rate Q of the carrier gas was changed to 48 [L/min], SH/Q=0.3, ST/Q=25, S/A=0.031, E/Q=0.5, and the film forming time was 30 minutes.

### (Example 3)

A film was formed in the same manner as in Example 1 except that the area S of the nozzle opening face 152 was changed to 12 [cm²], the difference H in the height position between the nozzle opening face 152 and the substrate 110 was changed to 0.1 [cm], the difference I in the height position between the ceiling of the film-forming chamber 107 and the substrate-placing face 113 of the substrate-placing member 112 was changed to 0.15 [cm], the flow rate Q of the carrier gas was changed to 12 [L/min], the gas-discharging amount E was changed to 12 [L/min], SH/Q=0.1, ST/Q=500, S/A=0.15, and the film forming time was 30 minutes.

### (Example 4)

A film was formed in the same manner as in Example 1 except that the shortest distance J [cm] between the substrate-placing region 114 and the inner face on the side wall of the film-forming chamber 107 was changed to 15 [cm], the area B [cm²] of the ceiling of the film-forming chamber 107 was changed to 1600 [cm²], B/A=20.4, and the film forming time was 150 minutes.

### (Example 5)

A film was formed in the same manner as in Example 1 except that the shortest distance J [cm] between the substrate-placing region 114 and the inner face on the side wall of the film-forming chamber 107 was changed to 5.0 [cm], the area B [cm²] of the ceiling of the film-forming chamber 107 was changed to 800 [cm²], B/A=10.2, and the film forming time was 240 minutes.

### (Example 6)

A film was formed in the same manner as in Example 1 except that the shortest distance J [cm] between the substrate-placing region 114 and the inner face on the side wall of the film-forming chamber 107 was changed to 0 [cm], the area B [cm²] of the ceiling of the film-forming chamber 107 was changed to 400 [cm²], B/A=5.1, and the film forming time was 180 minutes.

### (Example 7)

A film was formed in the same manner as in Example 1 except that the gas-discharging amount E was changed to 120 [L/min], E/Q=5.0, and the film forming time was 360 minutes.

### (Example 8)

A film was formed in the same manner as in Example 1 except that the gas-discharging amount E was changed to 360 [L/min], E/Q=15.0, and the film forming time was 60 minutes.

### (Example 9)

A film was formed in the same manner as in Example 1 except that a c-face sapphire substrate with 6 inch (150 mm in diameter) was used as the substrate 110, the flow rate Q of the carrier gas was 36 [L/min], the gas-discharging amount E was 36 [L/min], the longitudinal length L [cm] of the nozzle opening face 152 was 18 [cm], the area S of the nozzle opening face 152 was 9.0 [cm²], the area A of the substrate 110 was 176.7 [cm²], S/A=0.051, B/A=3.4, and the film forming time was 180 minutes.

### (Example 10)

A film was formed in the same manner as in Example 1 except that a c-face sapphire substrate with 6 inch (150 mm in diameter) was used as the substrate 110, the area B [cm²] of the ceiling of the film-forming chamber 107 was 176.7 [cm²], the flow rate Q of the carrier gas was 36 [L/min], the gas-discharging amount E was 36 [L/min], the longitudinal length L [cm] of the nozzle opening face 152 was 18 [cm], the area S of the nozzle opening face 152 was 9.0 [cm²], the area A of the substrate 110 was 176.7 [cm²], S/A=0.051, B/A=1.0, the film forming time was 60 minutes, and the substrate was not moved.

### (Example 11)

A film was formed in the same manner as in Example 1 except that an aluminum acetylacetonate complex was dissolved in a hydrochloric acid solution for preparing a solution at 0.1 mol/L to be used as the raw material solution, the film-forming apparatus in FIG. 13 was used, the difference I in the height position between the ceiling of the film-forming chamber 107 and the substrate-placing face of the substrate-placing member 112 was changed to 3.05 [cm], the film forming temperature T [°C] was changed to 550 [°C], ST/Q=137.5, and the film forming time was 60 minutes.

### (Example 12)

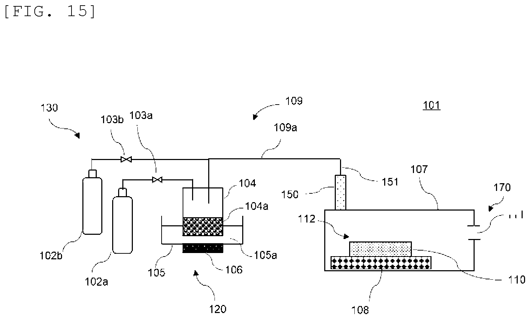

A film was formed in the same manner as in Example 1 except that gallium nitrate was dissolved in water for preparing a solution at 0.1 mol/L to be used as the raw material solution, the film-forming apparatus as in FIG. 15 having the film-forming chamber as in FIG. 8 was used, the substrate was not moved, and the film forming time was 60 minutes.

### (Measurement of Film Thickness Distribution)

Of the thin film formed on the substrate 110, film thickness at 81 measurement points in the face on the substrate 110 was measured by using a step profiler. From each of the values, an average film thickness was calculated and shown in Table 1. Further, Table 1 shows film thickness distribution calculated as (Film thickness distribution [±%]) = (Maximum film thickness - Minimum film thickness) / (Average film thickness) / 2 × 100. A value of the average film thickness divided by the film forming time was shown in Table 1 as a film forming rate.

**[Table 1]**

| | Raw material | B/A [-] | E/Q [-] | H [cm] | I [cm] | J [cm] | Substrate move | Film thickness [µm] | Growth Rate [µm] | Distribution [±%] |
|---|---|---|---|---|---|---|---|---|---|---|
| Example 1 | GaI₃ | 7.6 | 1.0 | 2.0 | 2.05 | 2.5 | reciprocation | 6.51 | 1.3 | 3.1 |
| Comparative Example 1 | GaI₃ | 7.6 | 1.0 | 2.0 | - | 2.5 | reciprocation | 0.64 | 0.6 | 34.1 |
| Comparative Example 2 | GaI₃ | 7.6 | 1.0 | 2.0 | 15.05 | 2.5 | reciprocation | 0.75 | 0.8 | 21.7 |
| Comparative Example 3 | GaI₃ | 7.6 | 0.0 | 2.0 | 2.05 | 2.5 | reciprocation | 0.91 | 0.9 | 15.4 |
| Example 2 | GaI₃ | 7.6 | 0.5 | 6.0 | 6.05 | 2.5 | reciprocation | 0.57 | 1.1 | 8.7 |
| Example 3 | GaI₃ | 7.6 | 1.0 | 0.1 | 0.15 | 2.5 | reciprocation | 1.15 | 2.3 | 4.2 |
| Example 4 | GaI₃ | 20.4 | 1.0 | 2.0 | 2.05 | 15 | reciprocation | 2.55 | 1.0 | 7.1 |
| Example 5 | GaI₃ | 10.2 | 1.0 | 2.0 | 2.05 | 5.0 | reciprocation | 5.14 | 1.3 | 4.9 |
| Example 6 | GaI₃ | 5.1 | 1.0 | 2.0 | 2.05 | 0 | reciprocation | 3.40 | 1.1 | 4.6 |
| Example 7 | GaI₃ | 7.6 | 5.0 | 2.0 | 2.05 | 2.5 | reciprocation | 7.54 | 1.3 | 4.3 |
| Example 8 | GaI₃ | 7.6 | 15.0 | 2.0 | 2.05 | 2.5 | reciprocation | 1.12 | 1.1 | ε.1 |
| Example 9 | GaI₃ | 3.4 | 1.0 | 2.0 | 2.05 | 2.5 | reciprocation | 4.00 | 1.3 | 3.8 |
| Example 10 | GaI₃ | 1.0 | 1.0 | 2.0 | 2.05 | 2.5 | none | 1.50 | 1.5 | 7.5 |
| Example 11 | Al(acac)₃ | 7.6 | 1.0 | 2.0 | 3.05 | 2.5 | reciprocation | 1.04 | 1.0 | 7.1 |
| Example 12 | Ga(NO₃)₃ | 7.6 | 1.0 | 2.0 | 2.05 | 2.5 | none | 1.20 | 1.2 | 8.2 |

From comparison between Examples 1 to 12 and Comparative Examples 1 to 3, it has been found that the film having excellent in-plane uniformity of the film thickness is obtained by using the film-forming apparatus having the mist-generating member, the carrier gas-supplying member, the film-forming member, the gas-discharging member, the nozzle placed in the film-forming member to supply the mist onto the substrate above the substrate-placing member on which the substrate to be placed, and the film-forming chamber including the substrate-placing member, wherein the film-forming chamber is set and provided so that the difference in the height position between the inner face of the ceiling of the film-forming chamber and the substrate-placing member is 0.15 cm or longer and 6.05 cm or shorter.

It is presumed that, between the film-forming apparatus and film-forming method according to Patent Document 5 and those according to the present invention, difference in placing mode of the substrate and presence or absence of the mechanism for rectifying the mist affect to fail to obtain the film having good in-plane uniformity of the film thickness in the example of forming a film on the substrate with 4 inch or larger described in Patent Document 5.

It should be noted that the present invention is not limited to the above-described embodiments. The embodiments are just examples, and any examples that substantially have the same feature and demonstrate the same functions and effects as those in the technical concept disclosed in claims of the present invention are included in the technical scope of the present invention.

## Claims

1. A film-forming apparatus, comprising:
a mist-generating member to atomize a raw material solution into a mist;
a carrier gas-supplying member to supply a carrier gas for carrying the mist generated in the mist-generating member; and
a film-forming member to thermally treat the mist carried with the carrier gas to form a film, wherein
the film-forming member comprises:
a film-forming chamber;
a substrate-placing member provided inside the film-forming chamber;
a nozzle to supply the mist toward the inside of the film-forming chamber; and
a gas-discharging member to discharge an exhaust gas from the inside to an outside of the film-forming chamber, and
a difference in a height position between an inner face of a ceiling of the film-forming chamber and a substrate-placing face of the substrate-placing member is 0.15 cm or longer and 6.05 cm or shorter.

2. The film-forming apparatus according to claim 1, wherein the inner face of the ceiling of the film-forming chamber and an opening face of the nozzle are present in an identical plane.

3. The film-forming apparatus according to claim 1 or 2, wherein the inner face of the ceiling of the film-forming chamber and the substrate-placing face of the substrate-placing member are in parallel.

4. The film-forming apparatus according to any one of claims 1 to 3, wherein a difference in a height position between the inner face of the ceiling of the film-forming chamber and a surface to be treated of the substrate placed on the substrate-placing member is 0.1 cm or longer and 6.0 cm or shorter.

5. The film-forming apparatus according to any one of claims 1 to 4, wherein, when an area of a surface to be treated of the substrate is A [cm²] and an area of the inner face of the ceiling of the film-forming chamber is B [cm²], A and B satisfy B/A≥1.0.

6. The film-forming apparatus according to any one of claims 1 to 5, wherein a shortest distance between an inner face of a side wall of the film-forming chamber and a substrate-placing region of the substrate-placing member is 5.0 cm or shorter.

7. The film-forming apparatus according to any one of claims 1 to 6, wherein the gas-discharging member is provided in a pair of directions of the film-forming chamber opposite to each other.

8. The film-forming apparatus according to any one of claims 1 to 7, further comprising a moving mechanism to move the substrate under the nozzle.

9. The film-forming apparatus according to any one of claims 1 to 8, wherein the raw material solution contains gallium.

10. The film-forming apparatus according to any one of claims 1 to 9, wherein the raw material solution contains a halogen.

11. A film-forming method of thermally treating an atomized raw material solution and forming a film on a substrate, the method comprising:
a mist-generating step of atomizing the raw material solution into a mist;
a mist-carrying step of carrying the mist with a carrier gas toward a film-forming chamber; and
a film-forming step of supplying and thermally treating the mist onto the substrate placed on a substrate-placing member in the film-forming chamber, and forming a film, wherein
in the used film-forming chamber, a difference in a height position between an inner face of a ceiling of the film-forming chamber and a substrate-placing face of the substrate-placing member is set to 0.15 cm or longer and 6.05 cm or shorter, and
in the film-forming step, the mist is supplied between the ceiling of the film-forming chamber and the substrate through a nozzle provided above the substrate-placing member, and an exhaust gas is discharged from above the substrate in the film-forming chamber toward an outside of the film-forming chamber to form a film while supplying the rectified mist onto the substrate.

12. The film-forming method according to claim 11, wherein, in the used film-forming chamber, the inner face of the ceiling of the film-forming chamber and an opening face of the nozzle are set to be present in an identical plane.

13. The film-forming method according to claim 11 or 12, wherein, in the used film-forming chamber, the inner face of the ceiling of the film-forming chamber and the substrate-placing face of the substrate-placing member are set to be in parallel.

14. The film-forming method according to any one of claims 11 to 13, wherein, in the used film-forming chamber, a difference in a height position between the inner face of the ceiling of the film-forming chamber and a surface to be treated of the substrate placed on the substrate-placing member is set to 0.1 cm or longer and 6.0 cm or shorter.

15. The film-forming method according to any one of claims 11 to 14, wherein, in the used film-forming chamber, when an area of the substrate is A [cm²] and an area of the inner face of the ceiling of the film-forming chamber is B [cm²], A and B are set to satisfy B/A≥1.0.

16. The film-forming method according to any one of claims 11 to 15, wherein, in the used film-forming chamber, a shortest distance between an inner face of a side wall of the film-forming chamber and a substrate-placing region of the substrate-placing member is set to 5.0 cm or shorter.

17. The film-forming method according to any one of claims 11 to 16, wherein, in the film-forming step, the exhaust gas is discharged in a pair of directions of the film-forming chamber opposite to each other.

18. The film-forming method according to any one of claims 11 to 17, wherein, when a flow rate of the carrier gas supplied thorough the nozzle is Q [L/min] and a flow rate of the exhaust gas is E [L/min], E/Q is set to 5.0 or less.

19. The film-forming method according to any one of claims 11 to 18, wherein, in the film-forming step, the substrate is moved under the nozzle.

20. The film-forming method according to any one of claims 11 to 19, wherein the used raw material solution contains gallium.

21. The film-forming method according to any one of claims 11 to 20, wherein the used raw material solution contains a halogen.

22. The film-forming method according to any one of claims 11 to 21, wherein a substrate having an area of a surface to be treated of 50 cm² or more or having a diameter of 4 inch (100 mm) or longer is used as the substrate.
